# EUROPÄISCHE PATENTSCHRIFT

(11) **EP 3 068 680 B1**
(45) Veröffentlichungstag und Bekanntmachung des Hinweises auf die Patenterteilung: **01.08.2018**
(21) Anmeldenummer: 14790024.5
(22) Anmeldetag: 10.10.2014
(51) Int. Cl.: B62J 1/00, B62J 1/12, B62J 99/00

(54) **ABSCHIRMUNG GEGEN ELEKTROMAGNETISCHE STRAHLUNG BEI EINEM ELEKTROMOTORRAD**
ELECTROMAGNETIC SHIELDING AT AN ELECTIC MOTORBIKE
BLINDAGE ELECTROMAGNÉTIQUE POUR UNE MOTOCYCLETTE ÉLECTRIQUE

(30) Priorität: 11.11.2013 DE 102013222809
(43) Veröffentlichungstag der Anmeldung: 21.09.2016
(73) Patentinhaber: Bayerische Motoren Werke Aktiengesellschaft, 80809 München (DE)
(72) Erfinder: WINKLER, Angelika, 85630 Grasbrunn (DE)
(86) Internationale Anmeldenummer: PCT/EP2014/071747
(87) Internationale Veröffentlichungsnummer: WO 2015/067430

(56) Entgegenhaltungen:
- EP-A1- 0 706 933
- EP-A1- 0 718 180
- EP-A1- 1 849 691
- WO-A1-01/15967
- WO-A1-2013/108747
- BE-A- 392 176
- DE-A1- 4 201 207
- FR-A- 1 037 775
- GB-A- 619 266

## Beschreibung

Die Erfindung betrifft ein Abschirmungselement gegen elektromagnetische Strahlung, das an einem Elektromotorrad im Sitzbereich angeordnet ist und elektromagnetische Strahlung von einem Fahrer und/oder Sozius abschirmt sowie eine Sitzbank mit einem daran angeordneten oder darin aufgenommenen Abschirmungselement.

Bei Fahrzeugen, insbesondere auch bei Motorrädern und Motorrollern, werden in den letzten Jahren neben den herkömmlichen Verbrennungsmotoren immer häufiger auch elektrische Antriebe eingesetzt. Bei den zweirädrigen Elektrofahrzeugen sitzt der Fahrer auf einer Sitzbank und ist den elektromagnetischen Feldern, die bspw. durch starke stromführende unterhalb der Sitzbank verlaufende Kabel entstehen, im Wesentlichen ungeschützt ausgesetzt. Zwar werden die Kabel isoliert, um die Abnahmevoraussetzungen bzgl. der elektromagnetischen Verträglichkeit (EMV) zu erfüllen, gleichwohl ist die Einwirkung elektromagnetischer Strahlung auf den Menschen gegeben. Durch die bisher durchgeführten Abnahmen zur elektromagnetischen Verträglichkeit wird hauptsächlich sichergestellt, dass Störeinflüsse von außen auf das Fahrzeug und von dem Fahrzeug auf die Umgebung ausgeschlossen sind. Der Faktor Mensch und seine Gesundheit bleibt ei dieser technischen Prüfung jedoch unberücksichtigt.

Weiterer Stand der Technik aus dem vorliegenden technischen Gebiet ist in den Druckschriften DE 42 01 207 A1, EP 1 849 691 A1, EP 0 718 180 A, GB 619 266 A, FR 1 037 775 A, EP 0 706 933 A1 und BE 392 176 A offenbart.

Bei Zweirädern ist die elektromagnetische Strahlung durch die sich unterhalb der Sitzbank erstreckenden Kabel deshalb besonders problematisch, da sie auf den vergleichsweise empfindlichen Genitalbereich des Fahrers und des Sozius einwirkt. Durch den geringen Abstand ist die Strahlungsbelastung vergleichsweise hoch.

Vor diesem Hintergrund ist es Aufgabe der vorliegenden Erfindung, eine Abschirmung mit günstiger Aufnahme bereitzustellen, die einen Schutz des Fahrers und Sozius gegenüber elektromagnetischer Strahlung bei Elektrozweirädern gewährleistet.

Erfindungsgemäß wird hierbei die Verwendung eines Abschirmungselements gegen elektromagnetische Strahlung in einer Sitzbank eines Elektromotorrades mit den in Patentanspruch 1 bestimmten Merkmalen vorgeschlagen. Das Abschirmungselement ist an einem Elektromotorrad im Sitzbereich angeordnet und schirmt elektromagnetische Strahlung von einem Fahrer und/oder Sozius ab. Eine günstige Aufnahme eines derartigen Abschirmungselements erfüllt die Lösung einer Sitzbank mit einem daran angeordneten oder darin aufgenommenen bzw. integrierten Abschirmungselement.

Als Abschirmungselement kann grundsätzlich jedes Bauteil verwendet werden, das geeignet ist, elektromagnetische Strahlung zurückzuhalten bzw. abzuschirmen. In einer beispielhaft vorteilhaften Ausführung ist vorgesehen, dass das Abschirmungselement ein 0,5 bis 3 mm dickes Stahlblech ist. Bei einer sehr dünnen Ausbildung kommt das Abschirmungselement einer Folie gleich, die besonders gut entlang der Form der Sitzbank als Auskleidung verwendet werden kann.

Ferner ist eine Ausführung günstig, bei der das Abschirmungselement in die Sitzbank integriert ist und sich über eine Fläche der Sitzbank erstreckt, die geeignet ist, den Fahrer mit Sozius gegenüber der von dem Elektromotorrad im Betrieb erzeugten elektromagnetischen Strahlung zu schützen. Das bedeutet, dass sich das Abschirmungselement im Wesentlichen über die gesamte Fläche der Sitzbank erstrecken sollte, wobei auch eine Erstreckung in Richtung des Rahmens des Elektromotorrades, d.h. seitlich nach unten zumindest teilweise mit umfasst ist.

Grundsätzlich ist in einer ersten Ausführungsform vorgesehen, das Abschirmungselement an einen Träger der Sitzbank zu befestigen, der üblicherweise aus Kunststoff gebildet ist. Bei einer Ausbildung des Abschirmungselementes als Folie kann dieses als innere Auskleidung des Trägers vorgesehen werden. In einem weiteren Ausführungsbeispiel ist alternativ vorgesehen, dass das Abschirmungselement in einen Kunststoffträger der Sitzbank mit eingespritzt wird, so dass es von außen unsichtbar bleibt.

In einer weiteren Ausführung ist vorgesehen, das Abschirmungselement selbst als Träger oder Teil des Trägers der Sitzbank auszubilden, wobei in einer günstigen Leichtbauform zwar der grundsätzliche Träger aus Kunststoff erhalten bleibt, jedoch das Abschirmungselement aus Stahl gebildet, zumindest abschnittsweise eine zusätzliche Trägerfunktion übernehmen kann. Beispielsweise kann das Abschirmungselement in einem Heckbereich der Sitzbank dicker ausgebildet werden, um Zusatzfunktionen wie das Bilden von Befestigungsvorrichtungen bereitzustellen. Hierzu ist in einer vorteilhaften Ausführung vorgesehen sein, dass das Abschirmungselement mindestens eine Aufnahme zur Befestigung mindestens eines Außenbauteils aufweist, so dass Bereiche der Sitzbank, bei denen auch das Abschirmungselement angeordnet ist, gegenüber Bereichen der Sitzbank, bei denen das Abschirmungselement nicht vorgesehen ist, in ihrer Steifigkeit und Kraftaufnahmefähigkeit verstärkt sind. Dabei ist möglich, in dem Abschirmungselement bspw. ein Gewinde vorzusehen, in das Schrauben zur Befestigung von Haltegriffen oder Gepäckträgern einbringbar sind.

Zur Reduzierung des Gewichts des Abschirmungselements selbst ist in einer günstigen Ausführung vorgesehen, dass das Abschirmungselement eine Lochung aufweist, die in ihrer Größe und/oder Verteilung angepasst ist, dass das Abschirmungselement die elektromagnetische Strahlung des Elektromotorrades gegenüber dem Fahrer und Sozius abhält. Die Lochung darf eine bestimmte Flächengröße nicht übersteigen, da ansonsten die Abschirmungsfunktion beeinträchtigt wäre. Die mögliche Flächengröße der Lochung wird mit bestimmt durch die Höhe der elektromagnetischen Strahlung des Elektromotorrades.

Erfindungsgemäß ist das Abschirmungselement mit einem leitfähigen Ableitelement verbunden ist. Dies kann bspw. der Rahmen oder ein sonstiges metallisches Bauteil sein, das geeignet ist, Ladungen aufzunehmen.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
- Fig. 1: eine seitliche Schnittansicht der Sitzbank; und
- Fig. 2: eine Schnittansicht von hinten der Sitzbank.

Die Figuren sind lediglich beispielhaft schematisch und dienen ausschließlich zum besseren Verständnis der Erfindung. Gleiche Bezugszeichen benennen gleiche Teile in allen Ansichten der Figuren.

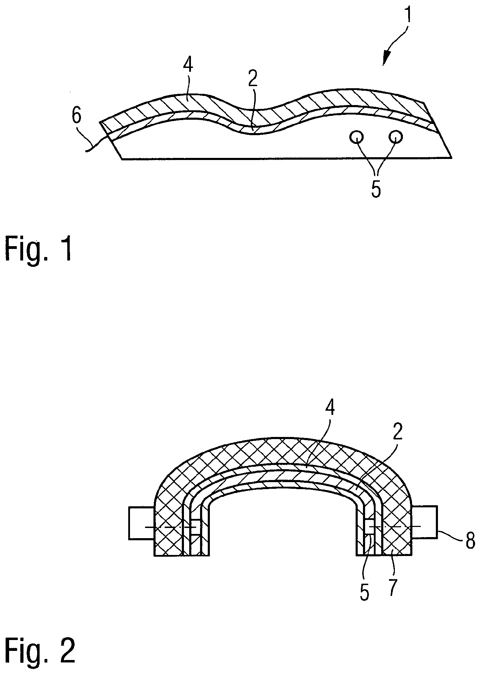

Fig. 1 zeigt eine seitliche Schnittansicht einer erfindungsgemäßen Sitzbank 1 ohne Polsterung. Ein Kunststoffträger 4 bildet das Grundgerüst der Sitzbank 1 und gibt ihre Form vor. Im Sitzbereich ist unterhalb des Kunststoffträgers 4 ein Abschirmungselement 2 in Form eines Stahlblechs vorgesehen, das sich als eigene Lage unterhalb des Kunststoffträgers 4 dem Unterbau des Elektromotorrads zuweisend erstreckt. Das Abschirmungselement 2 ist über ein Kabel 6 mit dem Rahmen oder einem sonstigen ladungsaufnehmenden Bauteil des Elektromotorrads verbunden. Im Heckbereich sind beispielhaft schematisch Aufnahmen 5 dargestellt, an denen Außenbauteile befestigbar sind.

Fig. 2 zeigt eine Sitzbank 1 in einer geschnittenen Heckansicht, wobei gegenüber der Darstellung aus Fig. 1 in Fig. 2 schematisch auch eine Polsterung 7 vorgesehen ist. Ferner ist das Abschirmungselement 2 nicht an dem Kunststoffträger 4 angeordnet, sondern in diesem aufgenommen. Dies kann dadurch erzielt werden, dass das Abschirmungselement 2 mit in den Kunststoffträger 4 eingespritzt wird. Das Abschirmungselement 2 erstreckt sich in Umfangsrichtung über die gesamte Bogenlänge der Sitzbank, so dass eine vollständige Abschirmung der elektromagnetischen Strahlung gegenüber dem Genitalbereich und den Oberschenkeln des Fahrers und Sozius erfolgt. Beispielhaft sind in Fig. 2 Haltegriffe 8 an der Sitzbank 1 vorgesehen, die in entsprechende Aufnahmen 5 verschraubbar sind. Das Abschirmungselement 2 ist aus diesem Grund in dem Heckbereich dicker ausgebildet, um als Kraftaufnahmeelement wirken zu können. Somit erfüllt es zwei Funktionen, nämlich die Abschirmung gegenüber elektromagnetischer Strahlung und die Versteifung der Sitzbank in vorbestimmten Bereichen.

Die Erfindung beschränkt sich in ihrer Ausführung nicht auf die vorstehend angegebenen bevorzugten Ausführungsbeispiele, da grundsätzlich das Abschirmungselement auch als extra-Bauteil an dem Motorrad befestigt werden kann, ohne es in die Sitzbank zu integrieren. Es ist ferner eine Anzahl von Varianten denkbar, welche von der dargestellten Lösung auch bei grundsätzlich anders gearteten Ausführungen Gebrauch macht. Beispielsweise kann das Abschirmungselement an bestehende Rahmenteile oder Sitzbänke mit Schnell- oder Clipverschlüssen nachgerüstet werden oder sich nur über einen Teil der Sitzbank erstrecken.

## Patentansprüche

1. Verwendung eines Abschirmungselements gegen elektromagnetische Strahlung, wobei das Abschirmungselement (2) an einem Elektromotorrad in eine Sitzbank (1) des Elektromotorrades integriert ist und elektromagnetische Strahlung von einem Fahrer und/oder Sozius abschirmt, wobei das Abschirmungselement als Stahlblech ausgebildet ist und mit einem leitfähigen Ableitelement verbunden ist.

2. Verwendung eines Abschirmungselements nach Anspruch 1, **dadurch gekennzeichnet, dass** das Abschirmungselement ein 0,5 - 3 mm dickes Stahlblech ist.

3. Verwendung eines Abschirmungselements nach zumindest einem der Ansprüche 1 bis 2, **dadurch gekennzeichnet, dass** das Abschirmungselement eine Lochung aufweist, die in ihrer Größe und/oder Verteilung angepasst ist, dass das Abschirmelement (2) die elektromagnetische Strahlung des Elektromotorrades gegenüber dem Fahrer abhält.

4. Verwendung eines Abschirmungselements nach einem der vorhergehenden Ansprüche, **dadurch gekennzeichnet, dass** das Ableitelement mit einem Chassis des Elektromotorrades verbunden ist.

## Claims

1. Use of an element for shielding against electromagnetic radiation, wherein the shielding element (2) on an electric motorcycle is integrated into a seat (1) of the electric motorcycle and shields electromagnetic radiation from a driver and/or passenger, wherein the shielding element is designed as a steel sheet and is connected to a conductive discharge element.

2. Use of a shielding element according to Claim 1, **characterised in that** the shielding element is a steel sheet 0.5 - 3 mm thick.

3. Use of a shielding element according to at least one of Claims 1 to 2, **characterised in that** the shielding element has perforations which are adapted in size and/or distribution such that the screening element (2) keeps the electromagnetic radiation of the electric motorcycle away from the driver.

4. Use of a shielding element according to one of the preceding claims, **characterised in that** the discharge element is connected to a chassis of the electric motorcycle.

## Revendications

1. Utilisation d'un élément formant écran contre le rayonnement électromagnétique dans laquelle l'élément formant écran (2) est intégré à une motocyclette électrique dans un siège (1) de celle-ci, et protège du rayonnement électromagnétique un conducteur et/ou un passager, l'élément formant écran étant réalisé sous la forme d'une tôle d'acier et étant relié à un élément de dissipation conducteur.

2. Utilisation d'un élément formant écran conforme à la revendication 1, constitué par une tôle d'acier ayant une épaisseur de 0,5 à 3 mm.

3. Utilisation d'un élément formant écran conforme à au moins l'une des revendications 1 et 2,
**caractérisée en ce qu'**
il comporte une perforation dont la dimension et/ou la répartition est(sont) adaptée(s) de sorte que l'élément formant écran (2) retienne le rayonnement électromagnétique de la motocyclette vis-à-vis du conducteur.

4. Utilisation d'un élément formant écran conforme à l'une des revendications précédentes,
**caractérisée en ce que**
l'élément de dissipation est relié au châssis de la motocyclette électrique.
